(19) Europäisches Patentamt / European Patent Office / Office européen des brevets

(11) **EP 3 366 806 A1**

(12) **DEMANDE DE BREVET EUROPEEN**

(43) Date de publication:
**29.08.2018   Bulletin 2018/35**

(51) Int Cl.:
**C23C 16/27** (2006.01)    **C23C 16/52** (2006.01)
**C23C 16/30** (2006.01)

(21) Numéro de dépôt: **18155872.7**

(22) Date de dépôt: **01.08.2011**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **30.07.2010   BE 201000472**

(62) Numéro(s) de document de la (des) demande(s) initiale(s) en application de l'article 76 CBE:
**11738724.1 / 2 598 669**

(27) Demande déposée antérieurement:
**01.08.2011 PCT/EP2011/063255**

(71) Demandeur: **Diarotech**
**6060 Gilly (BE)**

(72) Inventeur: **TELLEZ OLIVA, Horacio J.**
**6000 Charleroi (BE)**

(74) Mandataire: **Office Kirkpatrick**
**Avenue Wolfers, 32**
**1310 La Hulpe (BE)**

(54) **PROCEDE POUR SYNTHETISER PAR DEPOT CHIMIQUE EN PHASE VAPEUR UNE MATIERE, EN PARTICULIER DU DIAMANT, AINSI QU'UN DISPOSITIF POUR L'APPLICATION DU PROCEDE**

(57)     Procédé pour synthétiser par dépôt chimique en phase vapeur (CVD) une matière, suivant lequel on crée dans une chambre sous vide un plasma au voisinage d'un substrat, et suivant lequel on introduit dans la chambre une substance porteuse de carbone et du $H_2$ afin de produire dans la chambre un gaz comprenant des substances porteuses d' atomes de carbone réactif sous forme de radicaux ou de molécule insaturée à partir desquels la synthèse de ladite matière sera réalisée, et en ce que les spectres électromagnétiques d'absorption et de diffusion inélastique de la matière solide à synthétiser sont utilisés pour prélever dans ces spectres les fréquences d'absorption qui contribuent aux réactions qui mènent à la formation de la matière solide à synthétiser, et en ce que l'on produit des rayons énergétiques sous forme d'un faisceau de photons porteur de quantités d'énergie déterminée par chacune des fréquences correspondant auxdites fréquences d'absorption et de diffusion élastique, lequel faisceau de photons est injecté dans le plasma où, pour des états énergétiques de la matière solide, une absorption de ces photons ayant l'énergie correspondant à ces états énergétiques est réalisée par ladite substance porteuse des atomes de carbone réactif.

*Fig. 6*

EP 3 366 806 A1

**Description**

La présente invention concerne un procédé pour synthétiser par dépôt chimique en phase vapeur (CVD) une matière, en particulier du diamant, suivant lequel on crée dans une chambre sous vide un plasma au voisinage d'un substrat agencé à porter la matière à synthétiser, et suivant lequel on introduit dans la chambre une substance porteuse de carbone, en particulier du $CH_4$ ou du $C_2H_2$, et du $H_2$ afin de produire dans la chambre un gaz comprenant des substances porteuses d'atomes de carbone réactif sous forme de radicaux ou de molécules insaturées à partir desquels la synthèse de ladite matière sera réalisée.

Un tel procédé est connu du brevet US 4 859 490. Suivant le procédé connu on utilise une chambre sous vide, qui est maintenue à une pression entre 40 et 400 Torr et dans laquelle se trouve le substrat. Le plasma est créé à l'aide d'un potentiel électrique appliqué entre un filament et une grille, laquelle grille est située entre le filament et le substrat. Le filament est chauffé à une température d'au moins 1600° C et un gaz, porteur de carbone, ainsi que du $H_2$ sont introduits dans la chambre pour permettre de synthétiser par dépôt chimique en phase vapeur du diamant à partir du carbone.

Un désavantage du procédé connu est que la vitesse de dépôt de la matière solide à synthétiser est faible, de l'ordre de 1 µm par heure, ce qui fait que la procédure, même si elle procure un diamant de synthèse de bonne qualité, n'est d'un point de vue économique que peu rentable.

L'invention a pour but de réaliser un procédé pour synthétiser une matière par dépôt chimique en phase vapeur, lequel procédé permet d'obtenir une vitesse de dépôt plus élevée que celle du procédé connu tout en ayant une bonne qualité de la matière.

A cette fin un procédé suivant l'invention est caractérisé en ce que les spectres électromagnétiques d'absorption et de diffusion inélastique de la matière à synthétiser sont utilisés pour prélever dans ces spectres les fréquences d'absorption qui contribuent aux réactions qui mènent à la formation de la matière à synthétiser, et en ce que l'on produit des rayons énergétiques sous forme d'un faisceau de photons porteur de quantités d'énergie déterminées par chacune des fréquences correspondant auxdites fréquences d'absorption et de diffusion inélastique, lequel faisceau de photons est injecté dans le plasma où pour des états énergétiques de la matière solide une absorption de ces photons ayant l'énergie correspondant à ces états énergétiques est réalisée par les substances porteuses desdits atomes de carbone réactif. En produisant et en injectant des rayons énergétiques sous forme d'un faisceau de photons porteur d'énergie, qui chaque fois correspond précisément aux fréquences d'absorption (intrinsèques ou activés par défaut) et de diffusion inélastique (de photons et de neutrons), les substances porteuses desdits atomes de carbone réactif présents dans le plasma créé dans la chambre peuvent absorber une énergie qui correspond adéquatement à celle des états énergétiques de la matière à synthétiser. Ceci permet donc de mieux cibler l'énergie à absorber pour synthétiser le matériau que l'on souhaite obtenir. Ainsi, la probabilité de former des molécules de la matière à synthétiser est sensiblement augmentée, ce qui permet une vitesse de dépôt de la matière à synthétiser nettement plus élevée que celle du procédé connu. De plus en ciblant l'énergie à absorber la qualité de la matière à synthétiser est excellente.

De préférence l'on introduit un gaz porteur de carbone en tant que ladite substance. L'apport d'un gaz est facile à contrôler et permet une absorption plus efficace des rayons énergétiques.

De préférence, des rayons Infra Rouge sont utilisés en tant que rayons énergétiques pour réaliser un couplage entre les états énergétiques des radicaux ou des molécules insaturées et les états énergétiques des phonons de la matière. Ces rayons Infra Rouge couvrent une large gamme des fréquences présentes dans le spectre de la matière à synthétiser. Une première forme de réalisation préférentielle d'un procédé suivant l'invention est caractérisée en ce que la matière à synthétiser comporte une maille cristallographique qui détermine un ensemble de facies, par exemple l'octaèdre, ou le dodécaèdre dans le cas du diamant, représentée par deux jeux de vecteurs directionnels, le premier indiquant les directions normales aux principaux plans réticulaires, de plus haute densité atomique déterminant les facies possibles de ladite matière, le second étant constitué des vecteurs d'ondes permis pour la propagation des phonons en fonction de la structure cristallographique de la matière, ledit faisceau de photons étant orienté et injecté suivant des directions indiquées par lesdits deux jeux de vecteurs directionnels. Dans cette forme de réalisation le procédé consiste alors à injecter des faisceaux de photons possédant les énergies des modes de phonon ω qui sont orientés selon les vecteurs d'onde K correspondants, inscrits dans la zone de Brillouin, que l'on prélève sur les courbes de dispersion de ladite matière, par exemple aux points critiques et aux points de haute symétrie, en ce compris le centre de la zone noté couramment par Γ. Ces deux jeux de directions relatifs aux mailles respectives du réseau direct et du réseau réciproque, fournissent en définitive les directions choisies pour ledit faisceau de photons. En tenant compte de ces deux jeux de vecteurs lors de l'injection du faisceau de photons on parvient à augmenter la probabilité d'interaction entre les photons et les phonons et on contribue ainsi à augmenter la vitesse de dépôt de la matière à synthétiser.

Une deuxième forme de réalisation préférentielle d'un procédé suivant l'invention est caractérisée en ce qu'un faisceau de rayons UV-c est injecté dans le plasma. L'injection d'un faisceau d'UV-c permet en particulier d'augmenter la densité du plasma et ainsi stimuler la synthèse de la matière solide.

Une troisième forme de réalisation préférentielle d'un procédé suivant l'invention est caractérisée en ce que le plasma est produit par la création d'un champ électrique dans la chambre sous vide, ledit champ électrique étant créé à l'aide d'un premier et d'un deuxième potentiel électrique, ledit premier potentiel électrique est créé dans une première zone décalée dans le sens de la hauteur par rapport au substrat et le deuxième potentiel électrique est créé dans une deuxième zone située au voisinage direct du substrat, les premières et deuxièmes zones étant adjacentes l'une à l'autre, lequel premier et deuxième potentiels possèdent un gradient dirigé vers le substrat dont la pente du premier potentiel est plus élevée que celle du deuxième potentiel. Ceci permet de mieux concentrer les substances porteuses des molécules insaturées ou sous forme de radicaux tout autour du substrat et ainsi d'augmenter la probabilité de synthétiser du matériau.

L'invention concerne également un dispositif pour la mise en application d'un procédé suivant l'invention.

L'invention sera maintenant décrite plus en détail à l'aide des dessins qui illustrent un exemple de réalisation d'un dispositif suivant l'invention. Dans les dessins :

la figure 1a, b et c illustrent de façon schématique le dispositif suivant l'invention;
les figures 2 et 3 montrent des émetteurs pour produire le faisceau de photons;
la figure 4 illustre un émetteur pour produire des UV-c;
la figure 5 illustre le procédé suivant l'invention tel qu'il se produit dans le dispositif;
les figures 6 à 8 montrent des étapes du procédé;
la figure 9 montre un spectre d'absorption de diamant obtenu par CVD ;
la figure 10 montre un exemple de réalisation d'un système de focalisation du plasma;
la figure 11 montre un premier et un deuxième potentiel; et
la figure 12 illustre la première zone de Brillouin de la maille d'une matière telle que le diamant.

Dans les dessins une même référence a été attribuée à un même élément ou à un élément analogue.

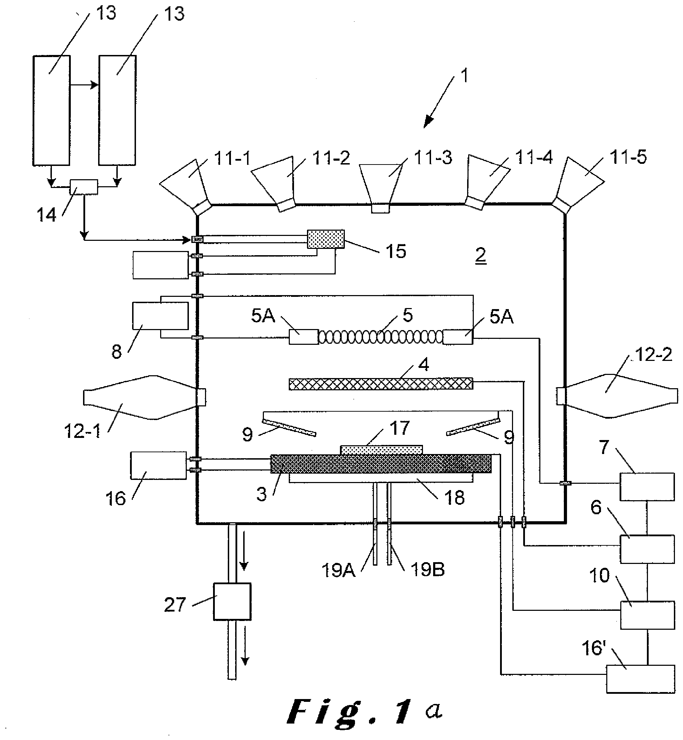

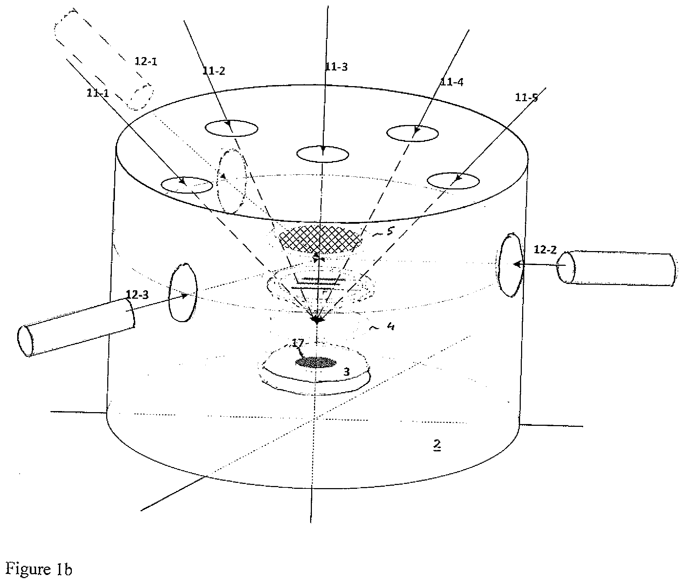

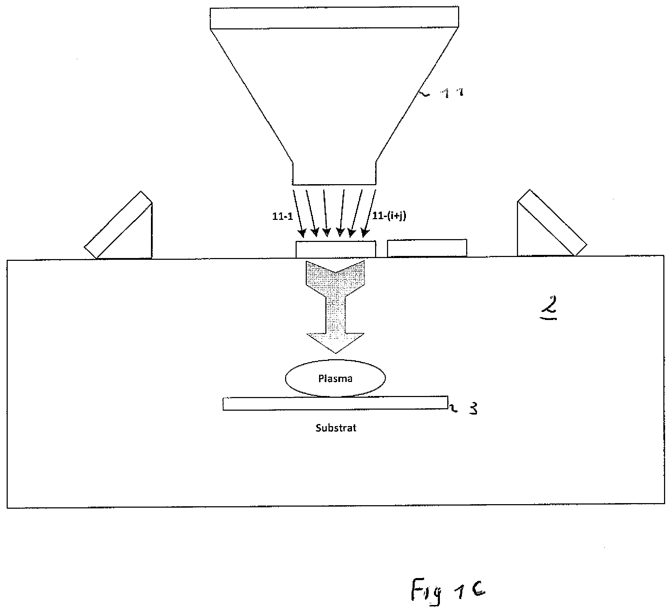

Les figures 1a, b et c illustrent de façon schématique un exemple de réalisation d'un dispositif suivant l'invention. La figure 1a montre la structure du dispositif, alors que la figure 1b montre la disposition dans l'espace des éléments du dispositif. Le dispositif 1 est agencé pour l'application d'un procédé pour synthétiser une matière par dépôt chimique en phase vapeur à filament chaud (HFCVD; Hot Filament Chemical Vapour Deposition). Il sera toutefois clair que le dispositif illustré permet également tout autre procédé pour synthétiser par dépôt chimique en phase vapeur (CVD) une matière et que l'invention n'est pas limitée au procédé HFCVD mais s'applique à tout procédé CVD.

Le dispositif 1 illustré aux figures 1, b et c comporte une chambre 2 sous vide, qui de préférence est amenée à une pression de $10^{-3}$ Torr avant de démarrer le procédé de synthèse. La mise sous vide de la chambre est réalisée de façon connue par exemple à l'aide d'une pompe. Dans la chambre se trouve un porte substrat 3, par exemple formé par un plateau, agencé à porter la matière 17 à synthétiser. Cette matière peut être toute substance compatible pour la réalisation du dépôt, comme par exemple du diamant, W, WCCo, WCNi silice, etc.

Le porte substrat est de préférence relié à une première source de tension 16 de courant alternatif pour des raisons qui seront décrites ultérieurement. Le cas échéant, le porte-substrat est également relié à une source de courant continue 16'. Le porte-substrat 3, est de préférence monté sur un plateau de refroidissement 18 servant à réguler la température du substrat. A cette fin, une entrée 19A et une sortie 19B de liquide de refroidissement sont reliées à ce plateau de refroidissement 18.

Au dessus du substrat se trouve une grille 4 et au dessus de la grille un filament 5. Le filament est de préférence monté entre deux collimateurs 5A, qui servent à focaliser le champ électrique pour une meilleure collimation du plasma. Les collimateurs permettent une meilleure distribution de la température, ainsi que du plasma dans la région du dépôt. Il faut noter également que l'invention n'est pas limitée à la position de la grille et du filament telle qu'illustrée aux figures 1 et b, et que ces positions peuvent être inversées.

La grille 4 est reliée à une deuxième source de tension 6 et le filament 5 à une troisième source de tension 7. La deuxième et la troisième sources de tension sont des sources de tension à courant continu. La grille peut, le cas échéant, également être reliée à une quatrième source de tension de courant alternatif (non repris dans le dessin). Le filament est également relié à une cinquième source de tension 8 qui est une source de tension de courant alternatif. Les premières, deuxièmes et troisièmes sources de tension servent à faire varier le potentiel électrique entre le substrat, la grille et le filament, alors que la cinquième source de tension 8 sert au chauffage du filament. Par la variation du potentiel électrique entre le substrat, la grille et le filament, il est possible de faire varier le champ électrique dans la chambre et ainsi de contrôler le plasma qui sera produit dans la chambre. La tension appliquée sur le filament et la grille peut varier entre 0.1 et 400 Volt en fonction de la matière à synthétiser. La grille sert essentiellement à régler le flux des substances chimiques porteuses de radicaux ou des molécules insaturées présentes dans la chambre, alors que le filament sert à réaliser l'activation du gaz.

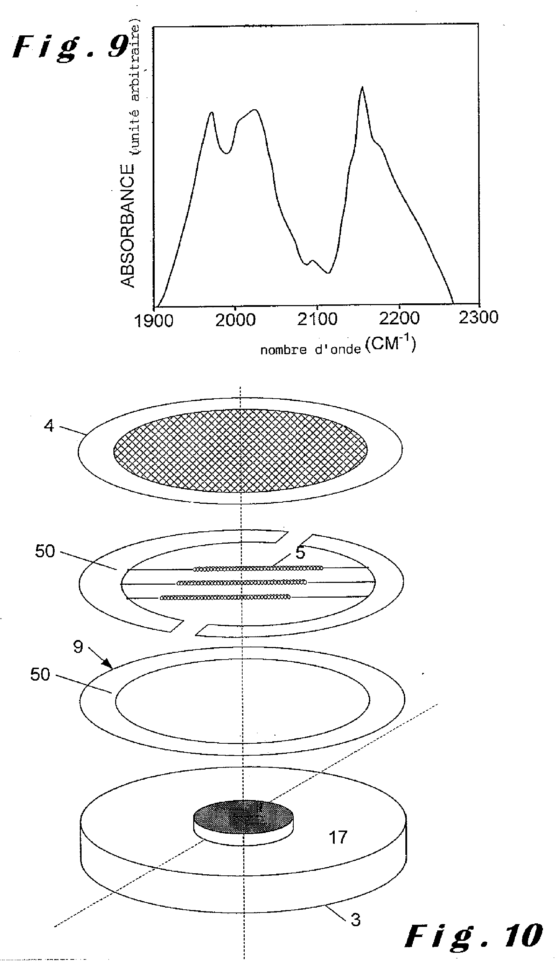

Le dispositif suivant l'invention comporte également un système 9 de focalisation du plasma placé en périphérie du substrat et agencé pour améliorer la distribution de la température et du plasma dans la région où la synthèse de la matière solide aura lieu et où s'effectue le dépôt. La figure 10 illustre un exemple d'un tel système 9 de focalisation du plasma. Le système de focalisation du plasma est par exemple formé par un anneau 50 placé autour du substrat et décalé vers le haut de la chambre par rapport au substrat. Le système de focalisation 9 peut également être formé par un jeu de fils en métal repliés sensiblement en forme de U inversé et placés autour du substrat. Le système de focalisation du plasma est alimenté par une sixième source de tension 10, qui fournit un courant continu. La forme d'anneau pour la focalisation du plasma en relation au filament est de préférence réalisée par deux demi-cercles placés de part et d'autre du porte-substrat. Le système 9 de focalisation du plasma est de préférence placé de façon inclinée vers le porte-substrat afin de mieux focaliser le plasma vers le substrat.

Le dispositif suivant l'invention comporte aussi des générateurs de faisceaux de photons 11-1 à 5 disposés au dessus de la chambre et agencés pour produire des rayons énergétiques, en particulier des rayons Infra Rouge (IR), sous forme d'un faisceau de photons. Le nombre de générateurs de faisceaux de photons est déterminé par la cristallographie de la substance et n'est donc pas limité à celui repris dans les figures 1 a et b. Il est également possible, comme dans la forme de réalisation illustrée à la figure 1c, qu'il n'y a qu'un seul générateur de faisceaux de photons. Ce ou ces générateurs servent à produire des rayons énergétiques dont la fréquence est déterminée par la fonction de densité spectrale $\Psi(\omega, K)$ de la matière à synthétiser, où $\omega$ représente la fréquence et $K$ le vecteur d'onde qui est polarisé ou non dans un plan, comme il sera décrit ci-dessous. Enfin, le dispositif est pourvu d'un générateur 12-1, 12-2 et 12-3 (ce dernier n'étant pas visible dans le dessin) de faisceaux de rayons UV-c. Ces derniers générateurs sont de préférence disposés suivant un cercle, avec chaque fois un angle de 120° entre eux pour des raisons de symétrie.

Il faut noter que pour des raisons de clarté seule la forme de réalisation des générateurs de faisceaux de photons agencés à produire des rayons Infra Rouge sera décrite. Toutefois, l'invention n'est pas limitée à cette forme de réalisation et d'autres rayons énergétiques du spectre électromagnétique qui interagissent avec la matière peuvent être utilisés (rayons X, UV, visible).

Puisqu'un plasma doit être produit à l'intérieur de la chambre 2, le dispositif suivant l'invention comporte également une entrée reliée à une source d'alimentation 13 permettant d'introduire dans la chambre une substance porteuse de carbone, en particulier sous forme de gaz porteur de carbone, et de l'hydrogène ($H_2$). La substance qui est introduite est bien entendu en relation avec la matière à synthétiser. La source est reliée à la chambre par l'intermédiaire d'une vanne 14 de contrôle de débit agencée pour régler le débit du gaz injecté dans la chambre. Pour la formation de diamant la substance porteuse de carbone est introduite dans la chambre pour y produire un gaz comprenant des substances porteuses d'atomes de carbone réactif sous forme de radicaux ou de molécules insaturées à partir desquels la synthèse de la matière sera réalisée. Le gaz porteur de carbone est par exemple du méthane ($CH_4$) ou de l'acétylène ($C_2H_2$). Cette réaction de synthèse est connue en soi et est par exemple décrite dans l'article de «J.E. Butler, Y.A. Mankelevich, A. Cheesman, Jie Ma et M.N.R. Ashfold» intitulé «Understanding the chemical vapor deposition of diamond : recent progress» et paru dans Journal of Physics condensed Matter 21, 2009. Le cas échéant le gaz peut être préchauffé à l'aide d'un chauffage 15 avant de rentrer dans la chambre. Une unité de pompage 27 du gaz est reliée à la chambre pour pomper le gaz et permettre un équilibrage de la pression de gaz qui règne à l'intérieur de la chambre. Pour la formation d'une autre matière que le diamant, la substance nécessaire pour la formation de ladite matière est introduite dans la chambre pour y produire un gaz comprenant des substances porteuses d'atomes de base de la matière réactive sous forme de radicaux ou de molécules insaturées à partir desquels la synthèse de la matière sera réalisée.

Au voisinage du substrat est situé la zone de dépôt. C'est dans la zone de dépôt que la réaction de synthèse a lieu et c'est pour cette raison que dans la zone de dépôt la distribution de température et la distribution des espèces chimiques à activer doivent être très homogènes.

Le procédé suivant l'invention est basé sur le phénomène physique de la résonance lors de l'excitation sélective et du couplage des états quantiques spécifiques des espèces chimiques actives et des états quantiques spécifiques du matériau à synthétiser. Ce matériau à synthétiser peut être tant un matériau solide, qu'un liquide ou même un gaz. L'objectif de l'invention est d'augmenter le rendement du procédé de synthèse en permettant des transitions sélectives au niveau des états quantiques. La méthode suivant l'invention favorise la probabilité de la formation par synthèse d'un matériau en imposant certains des états quantiques spécifiques, qui correspondent au spectre effectif ou apparent d'absorption de ce matériau au cours des étapes réactionnelles et qui conduisent à la formation de la matière.

Le procédé suivant l'invention favorise également la probabilité de la formation d'une espèce chimique en imposant certaines transitions quantiques spécifiques correspondantes à la matière à synthétiser. Enfin, le procédé favorise la probabilité de formation d'une espèce chimique, en imposant certains états quantiques spécifiques de l'espèce chimique à synthétiser aux étapes réactionnelles pendant la formation correspondante à ladite espèce chimique.

Dans le procédé suivant l'invention on introduit dans la chambre des énergies ($E^{DA}_{st}$) qui peuvent agir à différents moments dans la réaction, ou pendant toute la réaction. Ainsi on distingue :

-   $E^D_{st}$; qui est une énergie de dissociation dont la fonction est de rompre certaines des liaisons chimiques présentes dans la substance et de former de façon sélective, en particulier par résonance, des substances de départ ou des substances transitoires qui doivent ensuite mener à la matière à synthétiser. L'énergie de dissociation est par exemple produite par des rayons UV-c.

- $E^A_{st}$: qui est une énergie de structuration, de forme, d'agrégation ou configuration de la structure à former: Sa fonction est de fixer la structure de la substance à former ou à synthétiser.

La fonction densité spectrale [$\Psi(\omega,K)$] de la matière à synthétiser est composée d'une somme de fonctions des densités spectrales d'états

$$\Psi(\omega,K) = \Psi_E(\omega,K) + \Psi_V(\omega,K) + \Psi_R(\omega,K) + \Psi_T(\omega,K)$$

où $\Psi_E$ représente la fonction densités spectrales d'états électroniques, $\Psi_V$ la fonction densités spectrales d'états vibrationnels ou phoniques, $\Psi_R$ la fonction densités spectrales d'états rotationnels et $\Psi_T$ la fonction densités spectrales d'états de translation. De plus amples détails sur cette fonction densité spectrale d'états pour un exemple du diamant correspondante aux états vibrationnels sont décrits dans l'article de Claude Klein, Thomas Hartnett et Clifford Robinson, intitulé «Critical-point phonon frequencies of diamond» paru dans Physical Review B Vol 45 N° 22 du 1 juin 1992. En particulier pour le diamant la fonction densités spectrales d'états globaux est décrite par la somme de la fonction densités spectrales des états électroniques ($\Psi_E(\omega,K)$) et vibrationnels($\Psi_V(\omega,K)$). Lorsque la matière est formée par un liquide les états rotationnels doivent être pris en compte et pour un gaz les états de translation doivent être pris en compte.

Le procédé suivant l'invention fait appel à cette fonction de densité spectrale d'états ou à défaut au spectre électromagnétique effectif ou apparent d'absorption de la matière à synthétiser, voir pour exemple du diamant le spectre d'absorption repris en figure 9 de l'article de Klein et autres. Ces spectres électromagnétiques d'absorption sont des spectres intrinsèques à la matière, ou activés par défaut. Ces spectres électromagnétiques d'absorption sont également des spectres de diffusions inélastiques de photons ou de neutrons de la matière à synthétiser. Dans le spectre électromagnétique d'absorption on prélève les fréquences d'absorption ($f_i$) qui caractérisent la matière à synthétiser et contribuent ainsi aux réactions qui mènent à la formation de la matière à synthétiser.

Ainsi, par exemple en se référant toujours à l'article de Klein et autres on prend les 17 $1 \leq i \leq 17$ niveaux d'énergie repris à la table II, correspondant au spectre à deux phonons (et (ou) table I du même article correspondant au spectre à un phonon). A l'aide de ces niveaux d'énergie et des fréquences d'absorption qui y correspondent on va former pour chacune (i) de ces fréquences $f_i$ un faisceau de photons porteur d'une quantité d'énergie $E_i = hf_i$ où h est égal à la constante de Planck. On obtient ainsi dans l'exemple du diamant dix-sept faisceaux de photons ayant chacun une quantité d'énergie $E_i$ bien déterminée. Bien entendu le nombre de fréquences est fonction de la matière solide à synthétiser. Le choix de i=17 est lié à l'exemple de l'article de Klein et autres, mais ne limite en aucune façon l'invention.

Bien entendu on pourrait prendre toutes les fréquences du spectre de la matière à synthétiser reprises à la figure 9 dudit article. Mais en pratique il suffit de prendre les plus représentatives et celles nécessaires pour déterminer la matière. Ainsi on pourrait prendre les valeurs reprises au tableau III de l'article de R. Vogelgesang, A. Alvarenga, Hyunjung Kim, A. Ramdas et S. Rodrigues, intitulé : »Multiphonon Raman and infrared spectra of isotopically controlled diamond », paru dans Physical Review B, Volume 58, numéro 9 de septembre 1998 aux pages 5408 à 5416. Mais comme le montre ce tableau pas tous les niveaux d'énergie ont une activité dans la plage de fréquences des infrarouges et il n'est donc pas utile de produire un faisceau de photons pour ces fréquences qui n'ont pas d'activité.

L'énergie contenue dans chaque faisceau de photons représente donc l'énergie d'excitation de modes de phonons spécifiques de la matière à synthétiser. Ainsi, les substances porteuses d'atome de carbone réactif présentes dans le plasma, qui entrent en contact avec le photon et qui possèdent une fréquence d'absorption correspondant à celle des photons du faisceau vont subir, lorsqu'il s'agit d'une matière solide à synthétiser, des transitions vibrationnelles, ce qui va influer sur leur interaction avec le substrat (ou avec le solide déjà formé). Puisque l'énergie des photons correspond à celle des états phoniques du matériau à synthétiser il en résultera une interaction plus efficace et une réaction plus ciblée à la surface dudit matériau, ce qui entrainera un rendement supérieur du procédé par rapport au procédé déjà connu ou l'énergie se distribue sur toutes les fréquences de façon non sélective (électronique, vibrationnel, ....). Le procédé suivant l'invention fait appel au phénomène d'interaction, dans l'interphase du matériau et des substances porteuses d'atomes de carbone réactif, par l'intermédiaire des photons, pour un couplage optimal des deux systèmes.

Ces faisceaux de photons son injectés dans le plasma présent dans la chambre 2 à l'aide des générateurs 11-i. L'énergie reprise dans chaque faisceau de photons représente donc l'énergie nécessaire pour provoquer une absorption par résonance au niveau des états phoniques. Ainsi, les substances contenant des atomes de carbone réactif présents dans le plasma qui entrent en contact avec les photons dont la fréquence d'absorption correspond à celle de l'énergie dans le faisceau de photons, vont absorber cette énergie aboutissant ainsi à une réaction de synthèse plus avantageuse de la matière solide à former. Puisque l'énergie des photons correspond chaque fois à celle des états phoniques, une réaction plus ciblée, ayant une plus grande probabilité de mener à une absorption de l'énergie des photons sera provoquée, ce qui entraînera donc un rendement supérieur du procédé par rapport au procédé connu où l'énergie couvre toutes les fréquences de façon non sélective.

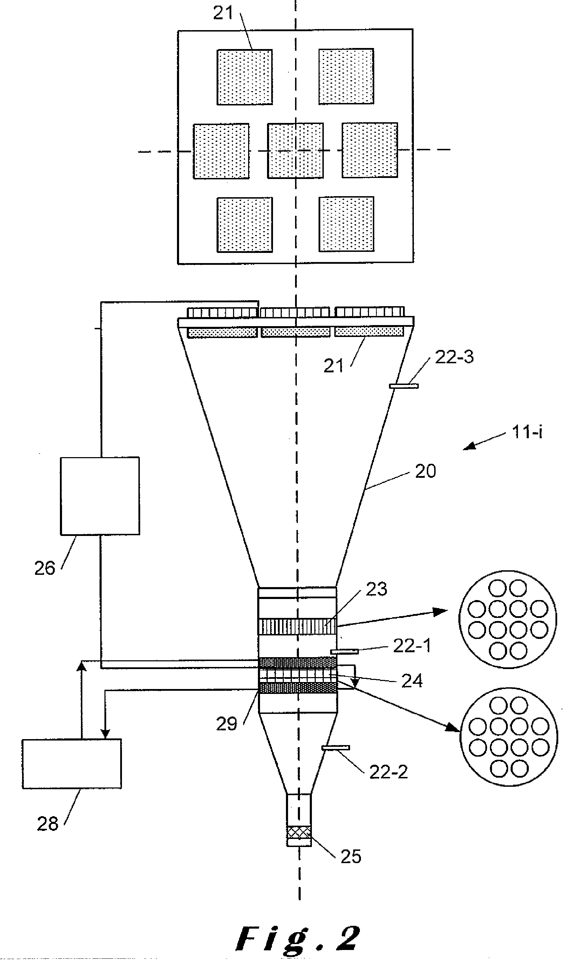

La figure 2 montre un exemple de réalisation d'un émetteur générateur (11-i) d'un faisceau de photons. Ce générateur permet de produire un faisceau de photons ayant les énergies $E_i$ correspondantes aux fréquences $f_i$ d'absorption choisies. Le générateur comporte un corps 20, de préférence fabriqué en cuivre pour permettre un haut rendement. Ce corps possède une géométrie tronconique et comprend à sa tête un ensemble de plaques chauffantes 21 en céramique formant un émetteur Infra Rouge (IR). Dans l'exemple illustré le générateur comporte sept plaques réparties sur l'ensemble de la surface et montrées dans la partie haute de la figure. Le générateur comporte également des entrées de gaz 22, par exemple de l'argon. Ce gaz sert à réduire l'oxydation de la paroi interne, ce qui permet à son tour de maintenir un indice de réflexion élevé pour celle-ci. Le gaz réduit également l'absorption des rayons Infra Rouge produits et contribue à la génération du faisceau de photons ayant des quantités d'énergie très sélectives. Le cas échéant une pompe 28 est prévue pour la circulation du liquide dans un système de refroidissement 29.

Un premier ensemble de filtres 23 à large bande de passage est monté près de l'entrée du tube tronconique. Ces filtres sont par exemple formés par des saphirs. Au lieu d'utiliser un ensemble de filtres il est également possible d'utiliser qu'un filtre, quoique cette dernière solution soit plus onéreuse. Cet ensemble de filtres permet de sélectionner la fréquence de l'énergie à produire. Un deuxième ensemble de filtres 24 à bande de passage étroit est monté en dessous du premier filtre, de telle façon que les premiers et deuxièmes ensembles de filtres se trouvent de part et d'autre de l'entrée de gaz 22-1. Ce deuxième ensemble est constitué des filtres optiques à multi-passage permettant de sélectionner l'ensemble des fréquences $f_i$ nécessaires à la réaction de synthèse. Au bout du générateur se trouve une lentille optique 25 qui sert de collimateur au faisceau de photons. Une source d'alimentation 26 en courant électrique couplée à un régulateur permet de contrôler la température de l'émetteur.

Ainsi, pour opérer le générateur de faisceau de photons, la fréquence de l'énergie à produire est appliquée à l'aide des premiers et deuxièmes ensembles de filtres 22 et 24. Les photons sont produits par l'émetteur 21 et l'énergie $f_i$ requise est obtenue par ajustement des ensembles de filtres 23 et 24. Ainsi sort du deuxième ensemble de filtres 24 un faisceau de photons ayant une énergie $E_i = hf_i$ pour la fréquence $f_i$ sélectionnée. La présence de plusieurs générateurs 11-i permet de générer à la fois plusieurs faisceaux énergies $E_i(fi)$ simultanément.

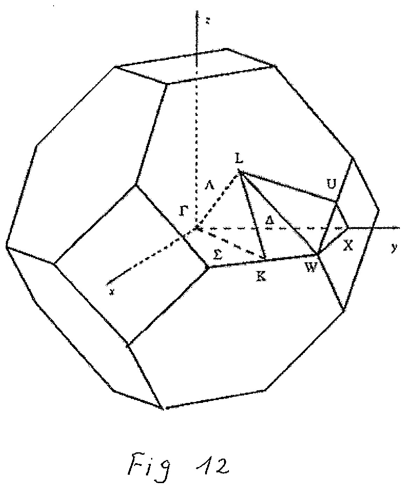

La matière à synthétiser possède une maille cristallographique à laquelle on peut associer deux jeux de vecteurs directionnels. Le premier jeu de vecteurs indique les directions normales aux principaux plans réticulaires de plus haute densité atomique déterminant les facies possibles de ladite matière solide, par exemple dans l'exemple du diamant, l'octaèdre ou le dodécaèdre. Le second jeu de vecteurs d'onde étant constitué des vecteurs d'ondes permis pour la propagation des phonons conformément à la structure cristallographique de la matière. Ceci est par exemple décrit plus en détail dans l'article de A. Ramdas intitulé «Raman, Brillouin and infrared spectroscopy of phonons in conventional diamond» publié dans IEE de juillet 2000. La figure 12 illustre la première zone de Brillouin de la maille d'une matière telle que le diamant avec les points de haute symétrie $\Gamma$, L, X, W, $\Sigma$, $\xi$.

Ledit faisceau de photons est orienté et injecté suivant des directions indiquées par lesdits deux jeux de vecteurs directionnels. Le procédé consiste également à injecter des faisceaux de photons possédant les énergies des modes de phonon $\omega$ et orientés selon les vecteurs d'onde K correspondants, inscrits dans la zone de Brillouin, que l'on prélève sur les courbes de dispersion de ladite matière solide à synthétiser, par exemple aux points critiques et aux points de haute symétrie, en ce compris le centre de la zone noté couramment par $\Gamma$. Ces deux jeux de directions relatifs aux mailles respectives du réseau direct et du réseau réciproque, fournissent en définitive les directions choisies pour ledit faisceau de photons. En tenant compte de ces deux jeux de vecteurs, lors de l'injection du faisceau de photons on parvient à augmenter la probabilité d'interaction et on contribue ainsi à augmenter la vitesse de dépôt de la matière solide à synthétiser.

Pour augmenter le rendement de la synthèse il est utile de tenir compte de cette cristallographie et d'injecter les faisceaux de photons en suivant les directions indiquées par les normales aux faces cristallines et (ou) également les directions correspondantes aux vecteurs d'onde autorisées pour la propagation de phonons. Il faut noter que si cette façon de procéder à la méthode suivant l'invention vient améliorer l'injection de photons décrite ci-dessus, l'injection peut également se faire directement sans tenir compte de ces directions privilégiées. Les générateurs sont montés de façon directionnelle sur la chambre afin justement de permettre cette possibilité.

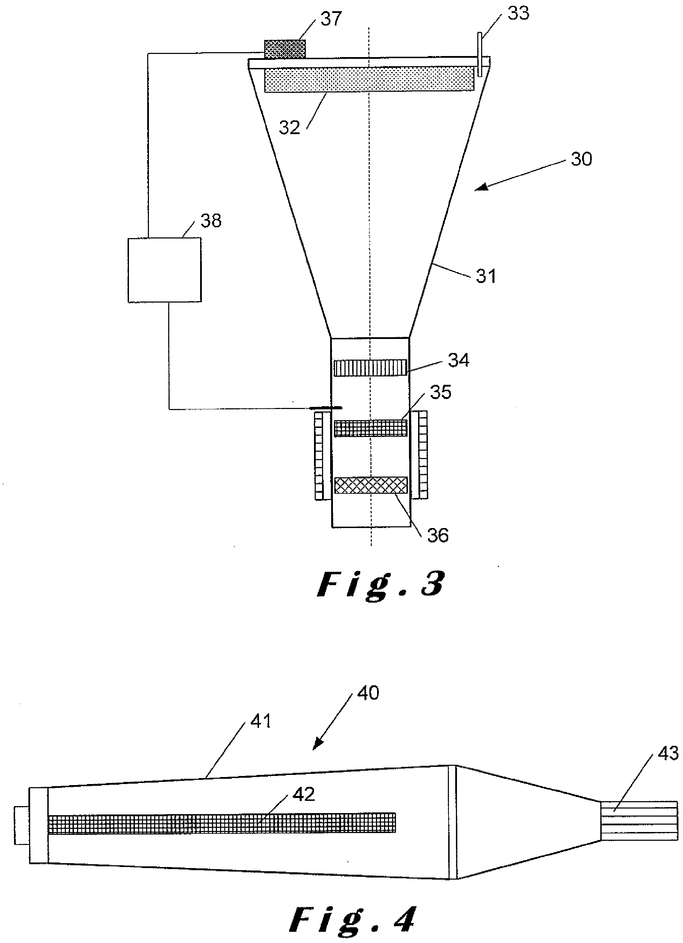

La figure 3 illustre un autre exemple de réalisation d'un générateur 30 mono-fréquence d'un faisceau de photons. Ce générateur comporte un corps d'émetteur 31 qui est également de préférence en cuivre pour permettre un indice de réflexion élevé des photons. Une plaque chauffante 32 en céramique comportant une bande étroite d'émission est montée dans la partie haute du corps ayant une géométrie tronconique. Une entrée de gaz 33 est également prévue sur la partie haute. Ce gaz joue le même rôle que celui décrit dans l'exemple de la figure 2.

Le générateur comporte un premier ensemble de filtres 34 à bande de fréquence large qui permet une présélection de la valeur de fréquence correspondant à $f_i$ par réduction de la bande passante. En même temps, ce premier filtre facilite la réduction de la chaleur produite dans le générateur. Un deuxième ensemble de filtres 35 à bande de passage étroit permet de sélectionner la fréquence fi voulue et une lentille optique 36 permet la collimation des faisceaux de photons. Enfin, l'alimentation 37 permet la fourniture en courant électrique et un régulateur 38 permet le réglage de température.

Pour davantage stimuler la synthèse de la matière, il est important qu'il y ait suffisamment de radicaux ou des molécules insaturées présentes dans le plasma. En effet, ces radicaux ou molécules insaturées sont des briques essentielles au dépôt de la matière. A cette fin, le procédé suivant l'invention comporte la production des faisceaux de rayons UV-c qui sont alors injectés dans le plasma. La figure 4 illustre un exemple de réalisation d'un tel générateur (40) de rayons UV-c. Ce générateur comporte un corps 41, de préférence fabriqué en aluminium pour permettre un indice de réflexion élevé des rayons UV-c. Une lampe 42 d'UV-c est montée à l'intérieur du corps 41. Cette lampe produit des rayons UV-c, qui sont envoyés vers un collimateur 43 en forme d'entonnoir. L'émetteur de rayons UV-c est de préférence placé sur un coté latéral de la chambre pour permettre une injection directe dans le plasma. Les rayons UV-c viendront ainsi stimuler la réaction $CH_4 \rightarrow CH^+_3 + H^-$ qui provoque ainsi une plus grande concentration de $CH^*_3$ qui vont contribuer à la synthèse de la matière voulue.

Pour encore augmenter le rendement du dépôt par synthèse de la matière, usage est fait d'un système de focalisation du plasma. La figure 10 montre une première forme de réalisation d'un tel système. Périphérique au porte-substrat 3 et décalé en hauteur par rapport au substrat 17, un anneau 50 est placé dans la chambre. L'anneau est situé en dessous du filament 5 et est relié à une source d'alimentation en courant électrique. Une deuxième forme de réalisation d'un système de focalisation du plasma peut être réalisée en remplaçant l'anneau de la figure 10 par un conducteur électrique configuré en une succession d'ondes bloc disposées en périphérie du porte-substrat 3. Tant l'anneau 50 que le conducteur électrique produisent un champ électrique dirigé vers le substrat qui va focaliser un plasma présent dans la chambre vers le substrat. Le système de focalisation du plasma se trouve entre la grille 4 et le substrat 3.

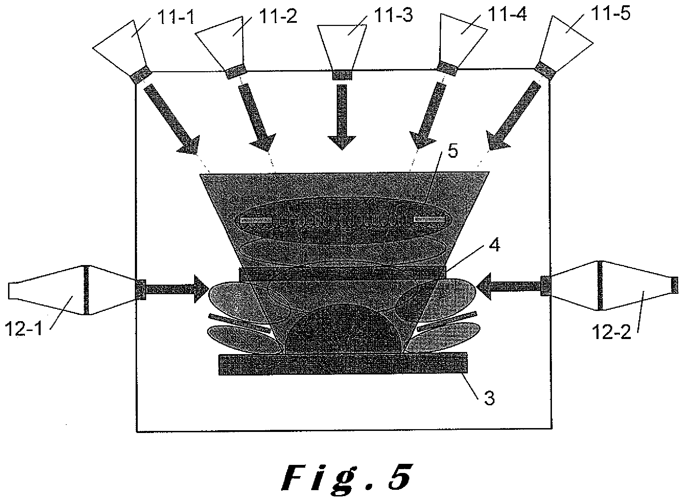

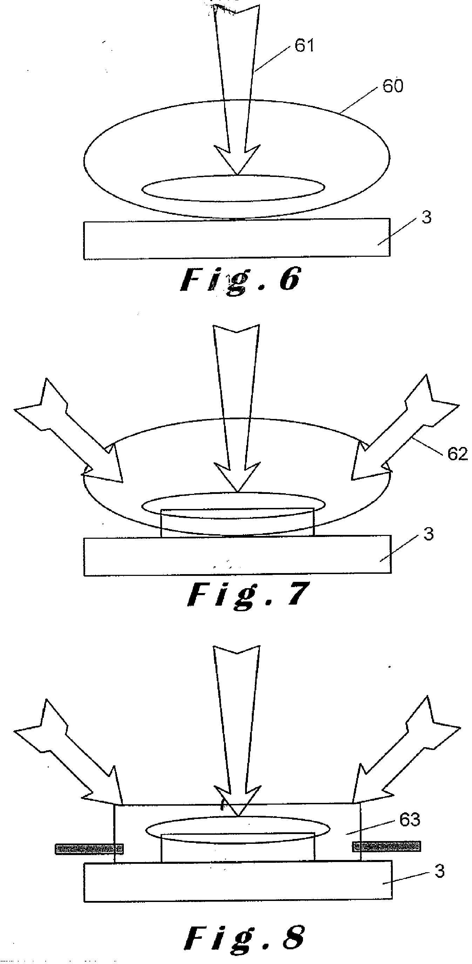

Le procédé suivant l'invention sera maintenant illustré à l'aide des figures 5 à 8 et 11. La grille 4 et le filament 5 permettent de créer un premier potentiel électrique dans une première zone RFG décalée dans le sens de la hauteur par rapport au substrat. Cette première zone est située aux alentours de la grille 4 et du filament 5. Le système de focalisation du plasma permet de créer un deuxième potentiel électrique dans une deuxième zone RD située en surface du porte-substrat 3. La première et la deuxième zones sont adjacentes l'une à l'autre afin de ne pas créer, pour ainsi dire, un vide entre le premier et le deuxième potentiels. Dans la chambre on trouve également une zone RPF du plasma autour du filament 5. Dans la première zone RFG le plasma est établi par la différence de potentiel entre le filament et la grille. Dans la zone RGC en périphérie du substrat, le plasma est établi par la différence de potentiel entre la grille et le système de focalisation 9, alors que dans la zone RCS, en dessous du système de focalisation, le plasma est établi par la différence de potentiel entre le système de focalisation et le porte-substrat.

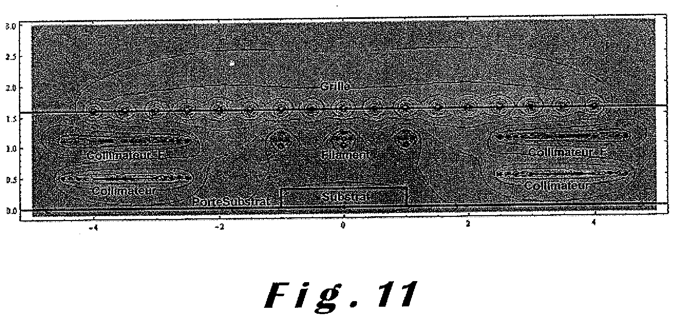

Eu égard à leur configuration et leur conception technique différente, le premier et deuxième potentiels possèdent chacun un gradient différent. Même si les deux champs électriques qui fournissent les potentiels sont dirigés vers le substrat, le taux de gradient du premier potentiel est plus élevé que celui du deuxième potentiel. La figure 11 montre la distribution du champ électrique dans la chambre. Pour faciliter la compréhension, la grille 4, le filament 5 et le substrat 3 ont été repris dans cette figure 11. Dans cette figure on voit comment le potentiel est concentré autour du substrat créant ainsi un puits de potentiel dans lequel se trouve le substrat. On voit en effet qu'autour du filament, le potentiel est concentré pour se prolonger au-dessus du porte-substrat. Ainsi, le dépôt par synthèse de la matière sera favorisé dans cette région du substrat. Autour de la grille on constatera que le champ électrique possède une configuration en boucle ovale. Dans l'exemple repris à la figure 11 la tension sur la grille est de 185V, sur le filament -25V, au porte-substrat -0,1V et le système de focalisation est à 20V. On voit également comment le potentiel produit par le système de focalisation tend à concentrer le plasma autour du porte-substrat.

Le procédé suivant l'invention sera maintenant illustré plus en détail à l'aide des figures 5 à 8. Dans la chambre 2 un plasma 60 est créé comme décrit au préalable et le gaz est introduit dans la chambre par la source d'alimentation 13. Les valeurs des premier et deuxième potentiels seront établies en fonction de la matière à synthétiser.

Sur base de la fonction de distribution spectrale ou à défaut de son spectre d'absorption de la matière à synthétiser, l'utilisateur va déterminer les différentes fréquences $f_i$ d'absorption afin de pouvoir à l'aide des générateurs 11 produire des faisceaux de photons 61 ayant les énergies $E_i = hf_i$ nécessaires à la synthèse de la matière. Dans la figure 5 est illustré comment en zone RI les rayons énergétiques sont introduits dans la chambre. Le cas échéant on peut polariser les rayons qui sont introduits dans la chambre. Dans ce dernier cas la direction du vecteur d'onde associé à la valeur de fréquence et le plan de polarisation du vecteur d'onde associé à la cristallographie de la matière sont pris en considération. L'énergie ainsi produite sera injectée dans le plasma où elle pourra être absorbée par les substances porteuses des atomes de carbone réactif présents dans le plasma. Puisqu'à proximité du substrat et à la surface de celui-ci le plasma est focalisé, une meilleure interaction énergétique entre les substances porteuses des atomes de carbone réactif et le substrat, où la matière déjà formée est présente, sera obtenue.

Une amélioration peut être obtenue en activant les générateurs 17 de rayons UV-c qui vont exciter, de façon sélective, les substances contenues dans le plasma. Ceci doit permettre d'augmenter la production dans le plasma d'une forme sélective contenant des radicaux ou des molécules insaturées et ainsi d'augmenter la probabilité d'une absorption d'énergie. Ces rayons UV-c sont introduits en zone RAS, c'est-à-dire dans la zone de la grille. Pour l'exemple du diamant les 17 valeurs de fréquences sont injectées dans le plasma selon le jeu de vecteurs L, W, $\Sigma$ et $\xi$. Quatre faisceaux suivant la direction du vecteur L, trois faisceaux suivant la direction du vecteur W, sept faisceaux suivant la

direction du vecteur $\Sigma$ et trois faisceaux suivant la direction du vecteur $\xi$. Enfin, à l'aide du système de focalisation il est possible de former un puits de plasma 63 autour du porte-substrat (zone RD) pour ainsi focaliser les substances contenant des atomes de carbone réactif autour du substrat.

L'invention n'est bien entendu pas limitée à la synthèse du diamant et peut être appliquée à d'autres matières à synthétiser. Ainsi par exemple le procédé suivant l'invention est applicable au dopage du diamant avec du Bore pour produire un supraconducteur. La condition pour l'obtention d'un supraconducteur est que la densité des atomes $n_B > 3 \times 10^{20}$ atomes/cm$^3$ (>600 ppm). Pour obtenir un supraconducteur le procédé suivant l'invention est au départ similaire à celui décrit pour la synthèse du diamant. Pour réaliser le dopage du diamant avec du Bore on introduit dans la chambre un gaz porteur du Bore, comme par exemple du trimethylborane ou de Boron-trichloride ou diborane, en particulier de diborane (C2H6) en proportion de 0.01 -200 ppm par rapport au H2, plus particulièrement de 1ppm à 20 ppm. Ce gaz porteur de Bore est par exemple introduit lorsque la couche de diamant possède déjà une épaisseur d'au moins 1 $\mu$m, en particulier d'environ 1 à 5 $\mu$m. On injecte également dans la chambre après la synthèse physico-chimique par résonance du diamant, un deuxième faisceau de photons à la fréquence correspondante à l'interaction électron-phonon qui provoque la supraconductivité. En particulier, on divise le deuxième faisceau de photons en un premier et un second fragment du deuxième faisceau et on injecte dans le plasma les deux fragments de faisceaux de photons correspondants à la fréquence de phonon dû à la présence de Bore et qui mène à l'apparition de la supraconductivité. Plus particulièrement le premier fragment du deuxième faisceaux de photons suivant la direction LO($\Gamma \rightarrow$ L et $\Gamma \rightarrow \xi$), et le second fragment du faisceaux de photons suivant la direction $\xi$, du jeu de vecteurs directionnels L, W, $\Sigma$, $\xi$ avec un décalage de 4meV par rapport à la valeur du diamant non dopée. De plus amples détails sur le mode phonon LO sont repris dans l'article de M. Hoesch et autres intitulé «Discovery of phonons causing superconductivity in diamonds looking for room temperature - superconductors in diamonds» paru dans JAEA R&D Review 2007, page 45.

Une éventuelle réduction de la puissance des différents faisceaux de photon correspondante au dépôt du diamant peut être envisagée, ceci proportionnelle à la différence d'énergie pour les liaisons de type B-C par rapport C-C. Cette réduction permet que la croissance du diamant ne domine pas la formation de la supraconductivité et facilite ou pondère ainsi le processus de substitution Carbone (C) par le Bore (B).

Une autre application du procédé suivant l'invention consiste à doper du diamant avec du Bore pour produire un semi-conducteur du type p. Une condition pour l'obtention d'un semi-conducteur est que la densité des atomes est de $n_B < 1 \times 10^{20}$ atomes /cm$^3$ (<600ppm). On utilise un gaz porteur de Bore similaire à celui utilisé pour former le supraconducteur mais avec une quantité de 0.01-100 ppm par rapport au H2, en particulier 0.1ppm à 10 ppm. On injecte également dans la chambre après la synthèse physico-chimique par résonance du diamant, un troisième faisceau de photons à la fréquence correspondante à l'interaction électron-phonon qui provoque la semi-conductivité. En particulier on divise le troisième faisceau de photons en un premier et un second fragment du troisième faisceau et on injecte dans le plasma les fragments de faisceaux de photons correspondants à la fréquence de phonon dû à la présence de Bore et qui mène à l'apparition de la semi-conductivité. Ainsi on injecte dans le plasma les cinq faisceaux de photons correspondants à la fréquence des phonons dû à la présence de Bore, responsable de la semi-conductivité. Le premier fragment formé de trois faisceaux qui sont injectés suivant la direction L et le second fragment comprend deux faisceaux qui sont injectés suivant la direction $\xi$, du jeu de vecteurs directionnels L, W, $\Sigma$, $\xi$. Tout comme pour la réalisation des supraconducteurs une éventuelle réduction de la puissance peut être envisagée.

Encore une autre application du procédé suivant l'invention consiste à doper du diamant avec de l'azote (N) pour produire un semi-conducteur du type n. Une condition pour l'obtention d'un semi-conducteur est que la densité des atomes est de 25 à 2 500ppm. On utilise un gaz porteur d'azote, comme par exemple de N2, NH$_3$, CH$_3$NH$_2$, en particulier le N2, avec un ratio de 0.1 à 1 de N2 par rapport au CH4. On introduit également dans la chambre après la synthèse physico-chimique par résonance du diamant, les photons à la fréquence correspondante à l'interaction électron-phonon qui provoque la semi-conductivité de type n. En particulier on injecte dans le plasma suivant le jeu de vecteurs directionnels les faisceaux de photons correspondants à la fréquence de phonon dû à la présence de l'azote pour de centre type C, et (ou) les trois faisceaux de photon correspondants à la fréquence de phonon dû à la présence de l'azote pour l'agrégat type A, et (ou) les quatre faisceaux de photons correspondants à la fréquence de phonon dû à la présence de l'azote pour l'agrégat type B.). Tout comme pour la réalisation des semi-conducteurs de type p, une éventuelle réduction de la puissance peut être envisagée.

Le procédé suivant l'invention permet également de doper le diamant avec du phosphore pour produire un semi-conducteur de type n. On utilise un gaz porteur de phosphore, comme par exemple le phosphane, (PH3), avec un ratio molaire phosphore/carbone de $4*10^{-2}$ à $4*10^{-5}$, en particulier de $2*10^{-2}$ à $1*10^{-3}$. On introduit également dans la chambre après la synthèse physico-chimique par résonance du diamant, un quatrième faisceau de photons à la fréquence correspondante à l'interaction électron-phonon qui provoque la semi-conductivité de type n. En particulier on injecte dans le plasma suivant le jeu de vecteurs directionnels les faisceaux de photons localisés à 523meV et 562 meV et correspondants à la fréquence de phonon dû à la présence de phosphores dans le réseau cristallin et responsable de la semi-conductivité. Une éventuelle réduction de la puissance peut être envisagée.

Le procédé suivant l'invention permet également de former par dopage un semi-conducteur de type Si-Ge (Silicium Germanium). Il faut noter que dans l'exemple du dopage du Si par le Ge, i'épitaxie du Ge sur le Si et la formation d'alliage de type $Si_{1-x}Ge_x$, dans le processus de CVD, mène à l'apparition de tension dans l'interface et à l'intérieur du cristal dû à la différence entre la constante du réseau du Si et celle du Ge. Ces tensions sont une source de défaut dans la structure cristalline. Aussi généralement l'hétéro épitaxie du Ge sur le Si débute par l'apparition des îles de Ge sur le Si. Ces îles sont en forme de pyramide et des pics qui peuvent mener jusque la formation des agrégats de Ge. Ceci a pour conséquence de former un dépôt inhomogène.

Un dépôt Si et de Ge est actuellement considéré de haute qualité si la densité de défaut dû à l'apparition de telles déformations est plus petite que 0.3 particules/cm2 avec une faible densité de dislocations plus petites que $10^6/cm^2$. Le procédé suivant l'invention, permet de former un dépôt Si-Ge qui aura moins d'imperfections telles que décrites et qui peut même les éliminer. A cette fin le procédé pour un dépôt de Si-Ge comporte :

(a) Une étape de dépôt chimique en phase vapeur (CVD) du Silicium sur un substrat de silicium pur ou sur un substrat vierge, à une température située entre 500 °C et 600 °C, de préférence à une température (T0) de 500°C, en présence d'Hydrogène. La pression dans la chambre est de préférence de 0.01mbar à 1000 mbar, en particulier de 0.1mbar à 1000 mbar, plus particulièrement de 1mbar à 800 mbar. Comme gaz précurseur de Silicium on utilise le, SiH2Cl2, le SiHCl3, le SiCl4 ou le Si(CH3)4 en particulier SiH4, jusqu'à l'obtention d'une épaisseur de couche de 3nm à 5nm de préférence. Un mélange d'un ou de plusieurs de ces gaz précurseurs peut également être envisagé. Pour obtenir une vitesse de dépôt plus élevée et un dépôt de qualité supérieure à celle du procédé de base, on injecte dans la chambre en pointant vers le substrat et suivant le jeu de vecteurs directionnels L, W, $\Sigma$, $\xi$ le faisceau de photons correspondant à la fréquence du phonon dû à la liaison Si-Si. Après avoir obtenu l'épaisseur de la couche désirée, l'apport du SiH4 est arrêté, ainsi que la température du faisceau de photon est abaissée jusqu'à 400° C à 550° C, de préférence de 430° C à 460° C en présence d'Hydrogène. La pression dans la chambre est de préférence de 0.01 mbar à 1000 mbar, en particulier de 1mbar à 800 mbar ;

(b) Une étape de stabilisation de la température du substrat à une première température (T1) de 400° C à 550° C, de préférence de 430° C à 460° C, plus particulièrement de 450° C en présence d'Hydrogène. La pression dans la chambre est de préférence de 0.01mbar à 1000 mbar, en particulier de 1mbar à 800 mbar;

(c) Une étape de dépôt chimique en phase vapeur (CVD) du germanium à la première température, dite T1 sur le substrat de Silicium pur ou sur le substrat de Silicium déjà obtenu après la CVD du Silicium, jusqu'à l'obtention d'une épaisseur de couche en germanium prédéterminée, ou une épaisseur de couche finale désirée obtenue sur la couche du Silicium, le gaz précurseur du germanium est de préférence GeH4. On injecte alors dans la chambre en pointant le substrat, suivant le jeu de vecteurs directionnels L, W, $\Sigma$, $\xi$ le faisceau de photons correspondant à la fréquence du phonon dû à la liaison Ge-Ge et le faisceau de photons correspondant à la fréquence du phonon dû à la liaison Si-Ge., Ce dernier agira pendant la formation des premières couches atomiques du Ge, c'est-à-dire pendant la formation de l'interface Si-Ge. Par la suite, la puissance du faisceau de photons correspondant à cette liaison (Si-Ge) sera diminuée, voir même mis à zéro, mais en maintenant la puissance du faisceau de photon correspondant à la liaison Ge-Ge. Ceci permettra d'obtenir une réduction du nombre des défauts dans le dépôt, c'est-à-dire obtenir un dépôt de qualité supérieure avec une vitesse de dépôt plus élevée. Cette étape est réalisée en présence d'hydrogène. La pression dans la chambre est de préférence de 0.01mbar à 1000 mbar en particulier de 1mbar à 800 mbar;

et, les étapes optionnelles :

(d1)-une étape dans laquelle le dépôt CVD du germanium et le faisceau de photons correspondant à la fréquence du phonon dû à la liaison Ge-Ge est arrêté, à une température inférieure de la température (T2) jusqu'à une troisième température (T3) de 500° C à 600° C, de préférence de 540 à 560° C, en particulier 550° *C,* étape réalisée en présence d'Hydrogène. La pression dans la chambre est de préférence de 0.01mbar à 1000 mbar en particulier de 1mbar à 800 mbar;

*(d2)*-une étape de dépôt CVD à la troisième température (T3) d'un alliage $Si_{1-x}Ge_x$, où $x \leqq 0.9$, jusqu'à l'obtention d'une couche intermédiaire de $Si_{1-x}Ge_x$ ayant l'épaisseur désirée. Le gaz précurseur du germanium est de préférence du GeH4. Le gaz précurseur pour le Silicium est SiH2Cl2, SiHCl3, SiCl4 et Si(CH3)4 en particulier SiH4. On injecte ensuite dans la chambre en pointant le substrat et suivant le jeu de vecteurs directionnels L, W, $\Sigma$, $\xi$ le faisceau de photons (IR), [et/ ou] les deux faisceaux de photons (IR et Raman) correspondant aux fréquences des phonons dû à la liaison Si-Ge. Cette étape est réalisée en présence d'Hydrogène. La pression dans la chambre est de préférence de 0.01mbar à 1000 mbar en particulier de 1mbar à 800 mbar;

*(d3)* une étape de transition, à la troisième température (T3), dans laquelle le dépôt CVD de l'alliage $Si_{1-x}Ge_x$, passe à un dépôt CVD du germanium pur. Le débit du gaz précurseur du Silicium est arrêté, pour réaliser le passage vers l'étape suivante. On arrête également le (les) faisceau de photons correspondant à la fréquence du phonon dû à la liaison Si-Ge, pour injecter le faisceau de photons correspondant à la fréquence du phonon dû à la liaison Ge-Ge. Le passage du faisceau de photons correspondant à la fréquence du phonon dû à la liaison Si-Ge vers photon correspondant la fréquence du phonon dû à la liaison Ge-Ge doit se faire de préférence de façon synchronisée, de préférence par décrément-incrément simultané de la puissance étape réalisée en présence d'Hydrogène. a pression dans la chambre est de préférence de 0.01mbar à 1000 mbar en particulier de 1mbar à 800 mbar;

(d4)- une étape dans laquelle le dépôt CVD du germanium est maintenu à cette température (T3) de manière à obtenir le dépôt du germanium comme couche supérieure et $Si_{1-x}Ge_x$ comme une couche intermédiaire. Pendant cette étape le faisceau de photons correspondant à la fréquence du phonon dû à la liaison Ge-Ge est maintenu. Cette étape est réalisée en présence d'Hydrogène et la pression dans la chambre est de préférence de 0.01mbar à 1000 mbar de préférence de 1mbar à 800 mbar;

(d5)-une étape dans laquelle la température de dépôt CVD de germanium est augmentée de la troisième température (T3) jusqu'à une quatrième température (T4) de 750 à 850° C, de préférence 800 à 850° C. Pendant cette étape le faisceau de photons correspondant à la fréquence du phonon dû à la liaison Ge-Ge est maintenu. T4 de préférence égal à T2, et l'étape est réalisée en présence d'Hydrogène, la pression dans la chambre est de préférence de 0.01mbar à 1000 mbar en particulier de 1 mbar à 800 mbar;

(e) Une étape d'incrémentation de la température du dépôt chimique en phase vapeur (CVD) du germanium de la première température (T1) à une deuxième température (T2) limitée à 750° C à 850° C, de préférence de 800° C à 850° C. Cette étape est réalisée sans la présence du faisceau de photons correspondant à la fréquence du phonon dû à la liaison Ge-Ge. Cette étape est toutefois réalisée en présence d'Hydrogène. La pression dans la chambre est de préférence de 0.01mbar à 1000 mbar en particulier de 1mbar à 800 mbar;

(f) Poursuite du CVD du germanium à la deuxième température (T2) jusqu'à l'épaisseur désirée de la couche de germanium. Le faisceau de photons correspondant à la fréquence du phonon dû la liaison Ge-Ge est maintenue. Cette étape est réalisée en présence d'Hydrogène et la pression dans la chambre est de préférence de 0.01mbar à 1000 mbar en particulier de 1mbar à 800 mbar.

## Revendications

1. Procédé pour synthétiser par dépôt chimique en phase vapeur (CVD) une matière présentant des spectres de fréquence électromagnétiques d'absorption et de diffusion inélastique, procédé suivant lequel on crée dans une chambre sous vide un plasma dans une zone de dépôt et on introduit dans la chambre un gaz porteur d'atomes de la matière à synthétiser afin de produire dans la chambre un gaz comprenant des substances porteuses d'atomes réactifs sous forme de radicaux ou de molécules insaturées à partir desquels la matière sera synthétisée, **caractérisé par le fait que**

   - on prélève dans lesdits spectres au moins une fréquence d'absorption qui contribue aux réactions qui mènent à la formation de la matière à synthétiser,
   - on produit des rayons énergétiques sous forme d'un faisceau de photons porteur de quantités d'énergie déterminées par ladite fréquence prélevée, et
   - on injecte ledit faisceau de photons dans le plasma où, pour des états énergétiques de la matière à synthétiser, une absorption des photons dudit faisceau, ayant l'énergie correspondant à ces états énergétiques, est réalisée par ledit gaz.

2. Procédé selon la revendication 1, dans lequel les substances porteuses desdits atomes réactifs présents dans le plasma créé dans la chambre peuvent absorber une énergie qui correspond à celle des états énergétiques de la matière à synthétiser.

3. Procédé selon l'une des revendications 1 et 2, dans lequel les rayons énergétiques comprennent des rayons infra-rouge.

4. Procédé selon la revendication 3, dans lequel la matière à synthétiser comporte une maille cristallographique représentée par deux jeux de vecteurs directionnels et dans lequel le faisceau de photon est orienté suivant des directions indiquées par lesdits jeux de vecteurs directionnels.

**5.** Procédé selon l'une des revendications 1 à 4, dans lequel les rayons énergétiques comprennent des rayons UV-c.

**6.** Procédé selon l'une des revendications 1 à 5, dans lequel le plasma est focalisé dans la zone de dépôt.

**7.** Procédé selon l'une des revendications 1 à 6, dans lequel les rayons énergétiques ont une fréquence déterminée par la fonction de densité spectrale de la matière à synthétiser, ladite fonction de densité spectrale étant les fréquences et les vecteurs d'onde des transitions quantiques de la matière à synthétiser.

**8.** Procédé selon l'une des revendications 1 à 7, dans lequel on introduit dans la chambre des rayons énergétiques dont la fonction est de rompre certaines des liaisons chimiques présentes dans la substance et de former de façon sélective des substances de départ ou des substances transitoires.

**9.** Procédé selon l'une des revendications 1 à 8, dans lequel la substance porteuse d'atomes de la matière à synthétiser est un gaz porteur d'au moins un des éléments de la liste constituée du carbone, du bore, du phosphore, de l'azote, du silicium et du germanium.

**10.** Procédé selon l'une des revendications 1 à 9, dans lequel la matière comprend au moins un des éléments de la liste constituée du carbone, du bore, du phosphore, de l'azote, du silicium, du tungstène, du cobalt et du germanium.

**11.** Procédé selon l'une des revendications 1 à 10, dans lequel la zone de dépôt est située au voisinage d'un porte substrat agencé à porter la matière à synthétiser.

*Fig. 1 a*

Figure 1b

11-1   11-(i+j)

Plasma

Substrat

Fig 1C

*Fig.2*

Fig. 3

Fig. 4

*Fig.5*

*Fig. 6*

*Fig. 7*

*Fig. 8*

Fig. 9

Fig. 10

**Fig. 11**

Fig 12

Europäisches
Patentamt

European
Patent Office

Office européen
des brevets

**RAPPORT DE RECHERCHE EUROPEENNE**

Numéro de la demande

EP 18 15 5872

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | LEE CHING-TING ET AL: "Crystalline SiGe films grown on Si substrates using laser-assisted plasma-enhanced chemical vapor deposition at low temperature", APPLIED PHYSICS LETTERS, AIP, AMERICAN INSTITUTE OF PHYSICS, MELVILLE, NY, US, vol. 91, no. 9, 30 août 2007 (2007-08-30), pages 91920-91920, XP012100867, ISSN: 0003-6951, DOI: DOI:10.1063/1.2779103 * pages 091920-1, colonne de gauche, dernier alinéa - colonne de droite, alinéa 1 * ----- | 1-11 | INV. C23C16/27 C23C16/52 C23C16/30 |
| A | US 4 898 748 A (KRUGER JR CHARLES H [US]) 6 février 1990 (1990-02-06) * colonne 3, ligne 51 - colonne 4, ligne 42 * ----- | 1-11 | |
| A | JIE MA ET AL: "Laser-aided diagnosis of the gas phase chemistry in microwave activated plasmas used for depositing diamond thin films", PROCEEDINGS OF THE 13TH INTERNATIONAL SYMPOSIUM ON LASER-AIDED PLASMA DIAGNOSTICS : 18 - 21 SEPTEMBER, 2007, HIDA HOTEL PLAZA, TAKAYAMA, JAPAN (IN: NIFS-PROC),, vol. 68, 18 septembre 2007 (2007-09-18), pages 206-211, XP009146265, * page 207, alinéa 2 * ----- -/-- | 1-11 | DOMAINES TECHNIQUES RECHERCHES (IPC) C23C |

Le présent rapport a été établi pour toutes les revendications

| Lieu de la recherche | Date d'achèvement de la recherche | Examinateur |
|---|---|---|
| Munich | 28 juin 2018 | Joffreau, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 18 15 5872

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | POPOV C ET AL: "Chemical bonding study of nanocrystalline diamond films prepared by plasma techniques", THIN SOLID FILMS, ELSEVIER-SEQUOIA S.A. LAUSANNE, CH, vol. 506-507, 26 mai 2006 (2006-05-26), pages 297-302, XP025005711, ISSN: 0040-6090, DOI: DOI:10.1016/J.TSF.2005.08.109 [extrait le 2006-05-26] * page 297, alinéa 2 - page 299, alinéa 3; figure 1 * ----- | 1-11 | |
| A | BUHLER J ET AL: "Back-scattering CARS diagnostics on CVD diamond", DIAMOND AND RELATED MATERI, ELSEVIER SCIENCE PUBLISHERS, AMSTERDAM, NL, vol. 8, no. 2-5, 1 mars 1999 (1999-03-01), pages 673-676, XP004364968, ISSN: 0925-9635, DOI: 10.1016/S0925-9635(98)00414-2 * le document en entier * ----- | 1-11 | |
| A | BUTLER J E ET AL: "Understanding the chemical vapor deposition of diamond: recent progress", JOURNAL OF PHYSICS: CONDENSED MATTER, INSTITUTE OF PHYSICS PUBLISHING, BRISTOL, GB, vol. 21, no. 36, 9 septembre 2009 (2009-09-09), page 364201, XP020164392, ISSN: 0953-8984, DOI: 10.1088/0953-8984/21/36/364201 * le document en entier * ----- | 1-11 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| Munich | 28 juin 2018 | Joffreau, P |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 18 15 5872

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-06-2018

| Document brevet cité<br>au rapport de recherche | Date de<br>publication | Membre(s) de la<br>famille de brevet(s) | Date de<br>publication |
|---|---|---|---|
| US 4898748 A | 06-02-1990 | AUCUN | |

## RÉFÉRENCES CITÉES DANS LA DESCRIPTION

**Documents brevets cités dans la description**

- US 4859490 A

**Littérature non-brevet citée dans la description**

- **J.E. BUTLER ; Y.A. MANKELEVICH ; A. CHEESMAN ; JIE MA ; M.N.R. ASHFOLD.** Understanding the chemical vapor deposition of diamond : recent progress. *Journal of Physics condensed Matter,* 2009, vol. 21
- **CLAUDE KLEIN ; THOMAS HARTNETT ; CLIFFORD ROBINSON.** Critical-point phonon frequencies of diamond. *Physical Review B,* 01 Juin 1992, vol. 45 (22
- **R. VOGELGESANG ; A. ALVARENGA ; HYUN-JUNG KIM ; A. RAMDAS ; S. RODRIGUES.** Multiphonon Raman and infrared spectra of isotopically controlled diamond. *Physical Review B,* Septembre 1998, vol. 58 (9), 5408-5416
- Discovery of phonons causing superconductivity in diamonds looking for room temperature - superconductors in diamonds. *JAEA R&D Review,* 2007, 45